(19) Europäisches Patentamt
European Patent Office
Office européen des brevets

(11) **EP 4 182 403 B1**

(12) **EUROPEAN PATENT SPECIFICATION**

(45) Date of publication and mention
of the grant of the patent:
**18.09.2024 Bulletin 2024/38**

(21) Application number: **22751732.3**

(22) Date of filing: **20.07.2022**

(51) International Patent Classification (IPC):
**C09K 11/77** (2006.01)    **C09K 11/61** (2006.01)

(52) Cooperative Patent Classification (CPC):
**C09K 11/7774; C09K 11/616; C09K 11/7706;**
**Y02B 20/00**

(86) International application number:
**PCT/EP2022/070378**

(87) International publication number:
**WO 2023/006550 (02.02.2023 Gazette 2023/05)**

(54) **A WHITE LIGHT EMITTING DEVICE**

**WEISSLICHTEMITTIERENDE VORRICHTUNG**

**DISPOSITIF ÉLECTROLUMINESCENT BLANC**

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(30) Priority: **27.07.2021 PCT/CN2021/108760**
**09.09.2021 EP 21195650**

(43) Date of publication of application:
**24.05.2023 Bulletin 2023/21**

(73) Proprietor: **Signify Holding B.V.**
**5656 AE Eindhoven (NL)**

(72) Inventors:
• **WU, Tung, Ching**
  **5656 AE Eindhoven (NL)**
• **HU, Xiao, Ye**
  **5656 AE Eindhoven (NL)**
• **WANG, Xiu, Ru**
  **5656 AE Eindhoven (NL)**
• **CHEN, Songhui**
  **5656 AE Eindhoven (NL)**
• **SHEN, Mo**
  **5656 AE Eindhoven (NL)**

(74) Representative: **Verweij, Petronella Daniëlle**
**Signify Netherlands B.V.**
**Intellectual Property**
**High Tech Campus 7**
**5656 AE Eindhoven (NL)**

(56) References cited:
**WO-A1-2017/021087      WO-A1-2020/190921**
**US-A1- 2017 342 320**

**Description**

FIELD OF THE INVENTION

This invention relates to the field of lighting and display devices. More specifically, this invention relates to white light emitting devices.

BACKGROUND OF THE INVENTION

Light emitting diodes (LEDs) are widely known in lighting and display devices as a replacement for traditional incandescent bulbs and/or fluorescent lighting. It is desirable to generate white light with high color purity at high efficiency.
There are two main approaches to generating white light from an LED. The first is to use a combination of multiple LEDs with different emission color s at different intensities. For example, blue, red and green emitting LEDs can be combined to produce white light. However, a problem with this approach is that the spectral power distribution of the component LEDs may be relatively narrow i.e., may have a full width half maximum (FWHM) of approximately between 10-30 nm. Wavelength ranges, therefore, exist in which it may be difficult to obtain high efficiency e.g. 580 nm.
The other main approach is to use a single color LED (with emission at a particular wavelength) in combination with a wavelength conversion material such as a phosphor. In this way, the wavelength conversion material absorbs light from the LED of a particular wavelength and emits the light at a different wavelength, normally at a longer wavelength (i.e. of lower energy). For example, a blue LED could be used with a yellow-green phosphor. However, there are currently limits to the efficiencies achieved using this method.
Typical white light emitting devices have efficiencies in the range of 150-200 lm/W and the current densities of the LED chips required to achieve these efficiencies are relatively high (typically between 0.2 to 0.5 A/mm$^2$). Accordingly, there is a need for a high efficiency white light emitting device using LEDs that does not suffer from the aforementioned problems.
In US 2017/342320 a wavelength conversion member is provided in which the following are dispersed in a thermoplastic resin: a LuYAG fluorescent material that is represented by $(Y_{1-a-beta}Lu_aCe_{beta})_3Al_5O_{12}$, that emits yellow-green light as a result of excitation by blue light, and a KSF fluorescent material that is represented by $K_2(Si_{1-x}Mn_x)F_6$ and that emits red light as a result of excitation by blue light. The content of the KSF fluorescent material in the wavelength conversion member is 1 to 5 times the content of the LuYAG fluorescent material by mass ratio. The wavelength conversion member makes it possible to provide a light-emitting device that has small color deviation, that is suitable as a lighting device, that emits white light, and that has good color rendering properties in a color temperature range of 4,000-6,500K, i.e., the color temperature range from white to daylight color.
WO 2020/190921 discloses an LED-filament comprising: a partially light-transmissive substrate; an array of LED chips on a front face of the substrate; first broad-band green to red photoluminescence materials and a first narrow-band manganese-activated fluoride red photoluminescence material covering the array of LED chips and the front face of the substrate; and second broad-band green to red photoluminescence materials covering the back face of the substrate. The LED-filament can comprise: no narrow-band manganese-activated fluoride red photoluminescence material on the back face of the substrate, or a second narrow-band manganese-activated fluoride red photoluminescence material on the back face of the substrate in an amount up to 5 wt percent of a total red photoluminescence material content on the back face of the substrate.
The invention in WO 2017/021087 provides a lighting device, configured to provide lighting device light, the lighting device comprising: - one or more light sources configured to provide light source radiation comprising deep blue radiation in the range of 400-440 nm and blue light in the range of 440-490 nm; - a first luminescent material configured to convert at least part of the light source radiation into first luminescent material light with light intensity in one or more of the green spectral region and yellow spectral region; a second luminescent material configured to convert (i) at least part of the light source radiation, or (ii) at least part of the light source radiation and at least part of the first luminescent material light into second luminescent material light with light intensity in the red spectral region, wherein the second luminescent material comprises a red luminescent material showing under excitation with at least part of the light source radiation, or (ii) at least part of the light source radiation and at least part of the first luminescent material light an emission in the range of 620-680 nm; wherein the lighting device is configured to provide at a first setting of the lighting device white lighting device light comprising deep blue radiation, blue light, first luminescent material light and second luminescent material light.

SUMMARY OF THE INVENTION

In light of this, an efficient white light emitting device is provided according to the claims. In a first aspect of the invention, there is provided a white light emitting device comprising: a substrate; at least one string of blue LED chips mounted on the substrate, with a dominant wavelength in the range from 445nm to 460nm; and a phosphor material composition comprising: a yellow green phosphor material which generates light with a peak emission wavelength in a range 520nm to 580nm; and a narrow band red phosphor material which generates light with a peak emission wavelength in a range 625nm to 635nm; wherein the phosphor material composition comprises the narrow band red phosphor material in an amount of from 33 to 49 wt. % for a CCT of from 4000 to 6500K or in an amount of from 60 to 70 wt. % for a CCT of from 2700 to 3500K CCT; and wherein the device is adapted to generate a white light output with an efficiency of at least 230 lm/W at a blue LED chip input current density in a range from 10 to 60 mA/mm$^2$, preferably in the range from 15 to 40 mA/mm$^2$ and more preferably in the range from 20 to 30 mA/mm$^2$.

Embodiments of the device have a high efficiency at a low LED input current density. This therefore provides a white LED that is significantly more efficient than existing LEDs (150-200lm/W) while also providing the required light color for general lighting applications. For example, the efficiency can be 230 lm/W to 235 lm/W, for example 230, 231, 232, 233, 234 or 235 lm/W. As set out below, embodiments provide this improvement through use of a blue LED chip that is more efficient through application of the specific current density and the improvement of the white spectrum efficiency through the use of the recited narrow band red phosphor amounts in a wavelength conversion phosphor material (e.g. covering the blue LED chips so as to modify the wavelength of the light).

The main components relating to the white LED device efficiency (Lm/W$_{white}$) are shown in the below equation:

$$Lm/W_{white} = WPE_{blue\ chip} \times CE_{phosphor} \times PE_{white} \quad (1)$$

WPE$_{blue\ chip}$ is the wall plug efficiency,
CE$_{phosphor}$ is the phosphor conversion efficiency and
PE$_{white}$ is the package efficiency.

The efficiency of the device measured in lumens/watt and can be calculated by standard LED photometric techniques.

Referring to the first and second components of the white LED device efficiency mentioned above in equation (1), the combination of the blue LED chips at a low current density in a range from 10 to 60 mA/mm$^2$ with the phosphor material composition comprising a narrow band red phosphor in the specified weight percentages for different CCT ranges, contribute to the high efficiency of at least 230 lm/W in this device. The specified weight percentages of the narrow band red phosphor materials are important as they determine the ratio of the narrow band red phosphor material to the yellow green phosphor material. The white light emitted from the device is made up of different colored components from the interaction of the blue LED chip with the phosphor materials. By incorporating the narrow band red phosphor materials at the specified weight percentages, the phosphor material composition has been found to provide the improved device efficiency for white light emission.

The narrow band red phosphor material can have a FWHM of ≤ 10 nm in a peak emission wavelength range from 625nm to 635nm. Phosphor conversion efficiency is typically lower for broad red emitter phosphors (i.e. those which have a broader spectral emission profile than narrow band red phosphors) compared to green / yellow green phosphors. The narrow spectral profile of a narrow band red band phosphor helps reduce red spectrum efficiency loss at the same time as maintaining a high color rendering index (CRI). The CRI is a measure of the color purity and is defined as the ability of a light source to accurately illuminate the color of an object as if it were being illuminated by an incandescent bulb or natural light source. It has therefore been found that the specific combination of materials in the device results in the high efficiency of the white light emitting device with high color rendering index.

The weight percentages of the narrow band red phosphor material present in the phosphor material composition are specific depending on the desired correlated color temperature "CCT". The CCT is the temperature of a heated black body radiator with emission that matches the color of a white light source. CCTs in the range of 2700 to 3500K are described as warm white with a yellower hue. CCTs of 4000 to 6500 K are described as neutral white to cool white. As such, in the first aspect, the device is either (i) a device having a CCT of from 4000 to 6500K (e.g. emitting light having a CCT of from 4000K to 6500K) and the narrow band red phosphor material is present in the composition in an amount of from 33 to 49 wt. %; or (ii) a device having a CCT of from 2700 to 3500K CCT (e.g. emitting light having a CCT of from 2700K to 3500K) and the narrow band red phosphor material is present in the composition in an amount of from 60 to 70 wt. %. It has been found that this narrower range of narrow band red phosphor material is particularly effective.

In some embodiments, the phosphor material composition comprises the narrow band red phosphor material in an amount of from 33 to 43 wt. % for a CCT of from 5000K to 6500K.

In some embodiments, the phosphor material composition comprises the yellow green phosphor material in an amount of from 44 to 74 wt. % for a CCT of from 4000 to 6500K or from 22-45 wt. % for a CCT of from 2700 to 3500K. The ratio of the yellow green phosphor material to the narrow band red phosphor material contributes to the white light color output and therefore the efficiency of the device in embodiments.

In some embodiments, the phosphor material composition comprises the yellow green phosphor material in an amount of from 51 to 67 wt. % and the narrow band red phosphor material in an amount of is from 33 to 49 wt. % for a CCT of from 4000 to 6500K.

In some embodiments, for a CCT of between 2700 to 3500K, the phosphor material composition further comprises a broad spectrum red phosphor material; and for a CCT of between 2700 to 3500K, the phosphor material composition comprises: the broad spectrum red phosphor material in an amount of from 1 to 4 wt. %; the yellow green phosphor material in an amount of from 30 to 35 wt. %; and the narrow band red phosphor material in an amount of from 64 to 66 wt. %.

In embodiments, the broad spectrum red phosphor material refers to a phosphor having a FWHM value of greater than or equal to 30 nm (at an emission range from 590 to 700 nm), for example this could be from 70-90 nm. Incorporation of this broad spectrum red phosphor material (e.g. a nitride phosphor such as $CaAlSiN_3:Eu^{2+}$ or $Sr_2Si_5N_8:Eu^{2+}$) into the phosphor composition is advantageous at the specified CCT ranges of between 2700-3500K to contribute to the provision of warmer white emission from devices.

In some embodiments, the phosphor material composition comprises the narrow band red phosphor material in an amount of: from 60 to 74 wt. % for a CCT of 2700K; from 55 to 69 wt. % for a CCT of 3000K; from 42 to 56 wt. % for a CCT of 4000K; or from 26 to 40 wt. % for a CCT of 6500K. These embodiments have been found to be particularly efficient for each respective CCT.

In some embodiments, the ccy position of the white light output is in a range 0.02-0.03 higher than the blackbody curve. The chromaticity of a particular light source may be referred to as the "color point" which has coordinates (ccx, ccy) in the CIE (Commission Internationale de l'eclairage in French, or International Commission on Illumination in English) color space diagram. In terms of white light, the "white point" may fall along a locus of chromaticity points corresponding to the color of light emitted by a black body radiator heated to a given temperature. This locus is termed the black body locus or BBL. It has been found that the specified increase of the ccy coordinate 0.02-0.03 above the BBL in this device can contribute to an improved efficiency. This efficiency of the device is improved as, at the specified ccy coordinate increase, the contribution from the yellow green phosphor emission is higher than that for the blackbody curve. Yellow green emission has high phosphor conversion efficiency and therefore, as this contribution is increased, the overall device efficiency is increased.

In embodiments, the white light (output) may be above the BBL and at a distance to the BBL of at least 5 SDCM, preferably at least 7 SDCM, more preferably at least 9 SDCM, even more preferably at least 10 SDCM, most preferably at least 15 SDCM. The obtained effect is improved performance of the white light emitting device according to the invention. The reason is that high quality white light (output) is obtained with a (relatively) low amount of red light in the white light. In this way, issues regarding quencing (of the red phosphor) is (further) reduced.

In embodiments, the white light (output) may have a color rendering index of at least 80, preferably at least 85, more preferably at least 88, most preferably at least 90. The white light emitting device according to the invention is particular suitable for achieving this high quality of light.

In some embodiments, the substrate and the string of blue LED chips are arranged as a LED filament. To generate sufficient lumen output, multiple blue LED chips on the substrate are needed and LED filaments have high design flexibility for chip size and substrate material combination. Incorporating an LED filament in the device can mimic the traditional configuration of an incandescent bulb, but with much improved efficiency. The use of a LED filament in embodiments is particularly beneficial as the efficiency is significantly improved without requiring, for example, a large heatsink. The efficiency associated with these LED filaments is, in part, owing to the presence of multiple smaller, lower-power LED chips than traditional LED filaments. Accordingly, it has been found that LED filament/filaments can contribute to higher efficiency of the device through lower driving currents.

A LED filament is providing LED filament light and comprises a plurality of light emitting diodes (LEDs) arranged in a linear array. Preferably, the LED filament has a length L and a width W, wherein L>5W. The LED filament may be arranged in a straight configuration or in a non-straight configuration such as for example a curved configuration, a 2D/3D spiral or a helix. Preferably, the LEDs are arranged on an elongated carrier like for instance a substrate, that may be rigid (made from e.g. a polymer, glass, quartz, metal or sapphire) or flexible (e.g. made of a polymer or metal e.g. a film or foil).

In case the carrier comprises a first major surface and an opposite second major surface, the LEDs are arranged on at least one of these surfaces. The carrier may be reflective or light transmissive, such as translucent and preferably transparent.

The LED filament may comprise an encapsulant at least partly covering at least part of the plurality of LEDs. The encapsulant may also at least partly cover at least one of the first major or second major surface. The encapsulant may be a polymer material which may be flexible such as for example a silicone. Further, the LEDs may be arranged for emitting LED light e.g. of different colors or spectrums. The encapsulant may comprise a luminescent material that is configured to at least partly convert LED light into converted light. The luminescent material may be a phosphor such as an inorganic phosphor and/or quantum dots or rods.

The LED filament may comprise multiple sub-filaments.

In some embodiments, the LED filament comprises a sapphire substrate. It has been found that sapphire substrates are particularly effective and can help to provide an additional efficiency to the device.

Each of the blue LED chips in the device can generate an output flux in the range 2lm to 4lm. For example, one blue LED chip can contribute around 3lm flux output to the device.

In some embodiments, the device further comprises an encapsulant over the blue LED chips which encapsulant comprises the phosphor material composition. The encapsulant can help to seal the phosphor material composition in close proximity to the blue LED chip.

In some embodiments, the yellow green phosphor material comprises yttrium aluminum garnet (YAG), gallium modified yttrium aluminum garnet GaYAG or lutetium modified yttrium aluminum garnet LuYAG. In some embodiments, the narrow band red phosphor material comprises $K_2SiF_6:Mn^{4+}$ (KSF). The KSF phosphor is relatively sensitive for high temperatures as the phosphor is susceptible for degradation at elevated temperatures. An advantage of the present invention is that as a result of the relatively low LED chip input current density, the LED chip has a relatively low temperature during operation of the white light emitting device.

In some embodiments, for a CCT of between 4000K to 6500K, the accumulated spectrum intensity ratio from 480nm to 600nm is higher than 50% of the total white spectrum from 380nm to 780nm; or for a CCT of between 2700K to 3500K, the accumulated spectrum intensity ratio from 480nm to 600nm is higher than 45% of the total white spectrum.

In some embodiments, the blue LED chip size is in the range $0.18mm^2$ to $0.30mm^2$. It has been found that this is the optimal size range for the blue LED chips in the device to contribute to the high efficiency.

In some embodiments, wherein the device comprises either two or three electrodes provided on the substrate. This type of arrangement can be termed a two-finger or three-finger layout. It has been found that by arranging electrodes on the substrate in this way, the forward voltage, $V_f$, can be reduced. Typically, the greater the number of electrode tracks/fingers, the lower the $V_f$. There is, however, a fine balance between the reduction in the forward voltage and an increase in forbidden light excitation. Embodiments providing two tracks have been found to be particularly efficient.

In some embodiments, the blue LED chip to chip distance is equal or greater than 0.4mm. The blue-chip emitting pattern is omnidirectional and therefore, by having the chip to chip distance of greater than or equal to 0.4 mm, the efficiency can be greatly improved. It has been found that at this distance, side emitting blue light absorbance by an adjacent chip is reduced. As a result, the $PE_{white}$ is increased which contributes to the overall efficiency of the device discussed with reference to equation (1). This may be, for example, greater than or equal to 0.4 mm and less than 2mm. For example, the distance could be in the range of 0.4 to 1.0 mm, 1.0 to 1.5 mm or 1.5 to less than 2 mm. The distance can be any value within these ranges, e.g. 0.4, 0.5, 0.6, 0.7, 0.8, 0.9 or 1 mm. In an embodiment, the blue LED chip to chip distance is equal or greater than 0.5mm.

In a second aspect, there is provided a white light emitting device comprising: a substrate; at least one string of blue LED chips mounted on the substrate, with a dominant wavelength in the range from 445nm to 460nm, wherein each blue LED chip is separated from an adjacent blue LED chip by a blue LED chip to chip distance; and a phosphor material composition comprising: a yellow green phosphor material which generates light with a peak emission wavelength in a range 520nm to 580nm; and a narrow band red phosphor material which generates light with a peak emission wavelength in a range 625nm to 635nm, wherein the blue LED chip to chip distance is equal or greater than 0.4 mm. This can generate a white light output with an efficiency of at least 230lm/W at a blue LED chip input current density in a range from 10 to 60 mA/mm$^2$, preferably in the range from 15 to 40 mA/mm$^2$ and more preferably in the range from 20 to 30 mA/mm$^2$.

In some embodiments, the phosphor material composition comprises the narrow band red phosphor material in an amount of from 26 to 56 wt. % for a CCT of from 4000 to 6500K or in an amount of from 55 to 74 wt. % for a CCT of from 2700 to 3500K CCT.

The combination of the blue LED chip spacing and the narrow band red phosphor material weight percentages has been found to contribute to high efficiency of the device in this aspect. As discussed above, the specific narrow band red phosphor material weight percentages determine the ratio of the yellow green to narrow band red phosphor in the phosphor material composition. Moreover, when the blue LED chip spacing distance is greater than or equal to 0.4 mm, the side emitting blue light absorbance by another chip is reduced and the packaging efficiency of the device is increased according to equation (1). Accordingly, it has been found that, at the resulting yellow green: narrow band red ratios, when the blue LED chip spacing is greater than or equal to 0.4 mm, the overall efficiency of the device is extremely high.

In some embodiments, the phosphor converted efficiency ($CE_{phosphor}$) can be enhanced by optimizing the phosphor recipe to increase the green relative spectrum ratio. Because green spectrum has a higher weight percentage of eye sensitive function, the calculated lumen output and efficiency is higher than normal white spectrum. The white spectrum color coordinate is calculated by the spectrum ratio of red/green/blue spectrum. Higher green spectrum content will lead to the LED having relatively higher y coordinate than normal white spectrum. In our study, the white LED efficiency can have 2-5 percentage improvement while shifting the y-coordinate 0.011 - 0.030 higher than the center in y-coordinate at 4000K defined in ANSI standard C78.377.

ANSI standard C78.377 is American National Standard for Electric Lamps - Specifications for the Chromaticity of Solid-State Lighting Products. Referring to Section 4, Chromaticity, the chromaticity coordinates and correlated color temperature (CCT) values used are based on the CIE colorimetry system. While the chromaticity of light is expressed by chromaticity coordinates such as (x, y). The chromaticity of nominally white light can also be expressed by CCT and the distance from the Planckian locus. In present disclosure, CIE 1961 (x-y) Diagram is used.

The coverage of higher y-coordinate color points can be described as below:

$$0.300 < x < 0.500;$$

and

$$-2.3172\,x^2 + 2.3653\,x - 0.170 < y < -2.3172\,x^2 + 2.3653\,x - 0.146.$$

This can generate a white light output with an efficiency of at least 230lm/W at a blue LED chip input current density in a range from 10 to 60 mA/mm$^2$ and preferably from 20 to 30 mA/mm$^2$.

In some embodiments, the defined higher y-coordinate color points coverage can be described by MacAdam ellipses according to ANSI C78.376. MacAdam ellipses is a common language to define white color points coverage. The Macadam ellipses coverage can be defined with below parameters, including reference point color coordinate (Reference x, Reference y), the ellipse parameters (G11/G12/G22), SDCM size (K). Because different CCT have different reference point, the formula of Macadam ellipses coverage is:

$$G11 * \Delta x^2 + 2G12 * \Delta x * \Delta y + G22 * \Delta y^2 = 1 * K$$

$$tan2\theta = \frac{2G12}{G11 - G22}$$

$$a = \sqrt{\frac{2}{G11 + G22 + \frac{2G12}{sin2\theta}}}$$

$$b = \sqrt{\frac{2}{G11 + G22 - \frac{2G12}{sin2\theta}}}$$

Δx means the x direction distance between ellipse boundary point vs. reference point (Reference x);
Δy means the y direction distance between ellipse boundary point vs. reference point (Reference y).

Yet further, in embodiments the correlated color temperature (CCT) is especially within about 15 SDCM (standard deviation of color matching) from the BBL (black body locus), especially within about 10 SDCM from the BBL, even more especially within about 5 SDCM from the BBL (black body locus) or blackbody curve.

Another method to describe MacAdam ellipses coverage is to use SDCM size (K), the ellipse major axis (a), the ellipse minor axis (b), the ellipse rotation angle(θ). The translation formula between G1 1/G12/G22 vs. a/b/ 0 be listed below.

The MacAdam ellipses coverage is changed with CCT, below is the examplar coverage of higher y-coordinate color points for various CCT ranges.

| CCT | Reference x | Reference y | G11 | G12 | G22 | SDCM | θ (unit: degrees) | a | b |
|---|---|---|---|---|---|---|---|---|---|
| 2700K | 0.4771 | 0.4415 | 5.15E+05 | -1.80E+05 | 2.56E+05 | 5 | 62.81 | 1.24E-02 | 6.42E-03 |
| 3000K | 0.4507 | 0.4372 | 5.13E+05 | -1.79E+05 | 2.30E+05 | 5 | 64.14 | 1.32E-02 | 6.45E-03 |
| 3500K | 0.4178 | 0.4242 | 4.59E+05 | -1.81E+05 | 2.09E+05 | 5 | 62.33 | 1.48E-02 | 6.72E-03 |
| 4000K | 0.3868 | 0.4088 | 3.89E+05 | -1.85E+05 | 1.99E+05 | 5 | 58.56 | 1.70E-02 | 7.06E-03 |
| 5000K | 0.3479 | 0.3829 | 4.54E+05 | -2.02E+05 | 2.18E+05 | 5 | 60.19 | 1.56E-02 | 6.63E-03 |
| 6500K | 0.3097 | 0.3508 | 6.94E+05 | -2.95E+05 | 3.35E+05 | 5 | 60.64 | 1.22E-02 | 5.39E-03 |
| Here E means exponent of 10, for example, 5.15E+05 = $5.15 \times 10^5$. | | | | | | | | | |

The term "luminescent material" herein especially relates to inorganic luminescent materials, which are also sometimes indicated as phosphors. These terms are known to the person skilled in the art.

In embodiments, quantum dots may be applied, and may optionally be embedded in transmissive matrices like e.g. polymers, like PMMA, or polysiloxanes, etc. etc. Quantum dots are small crystals of semiconducting material generally having a width or diameter of only a few nanometers. When excited by incident light, a quantum dot emits light of a color determined by the size and material of the crystal. Light of a particular color can therefore be produced by adapting the size of the dots. Most known quantum dots with emission in the visible range are based on cadmium selenide (CdSe) with a shell such as cadmium sulfide (CdS) and zinc sulfide (ZnS). Cadmium free quantum dots such as indium phosphide (InP), and copper indium sulfide ($CuInS_2$) and/or silver indium sulfide ($AgInS_2$) can also be used. Quantum dots show very narrow emission band and thus they show saturated colors. Furthermore, the emission color can easily be tuned by adapting the size of the quantum dots. Any type of quantum dot known in the art may be used in the present invention. However, it may be preferred for reasons of environmental safety and concern to use cadmium-free quantum dots or at least quantum dots having a very low cadmium content. Instead of quantum dots or in addition to quantum dots, also other quantum confinement structures may be used. The term "quantum confinement structures" should, in the context of the present application, be understood as e.g. quantum wells, quantum dots, quantum rods, tripods, tetrapods, or nano-wires, etcetera.

Especially, the luminescent material is configured to convert at least part of the light source light into luminescent material light having an emission band having wavelengths in one or more of (a) the green spectral wavelength range and (b) the yellow spectral wavelength range, wherein the luminescent material comprises a (garnet) luminescent material of the type $A_3B5O_{12}$:Ce, wherein A comprises one or more of Y, La, Gd, Tb and Lu, and wherein B comprises one or more of Al, Ga, In and Sc. Hence, the luminescent material light may e.g. green light or yellow light (or in specific embodiments even orange (dependent upon the composition of the garnet and cerium concentration)). However, other embodiments are also possible, see below. In embodiments, 0.05-10% of the A elements comprise Ce, even more especially 0.05-5%, such as 0.1-5%. Especially, embodiments, 0.1-3% of the A elements comprise Ce, such as up to 2%, like selected from the range of 0.1-1.5%, such as at least above 0.5%.

Alternatively or additionally, the luminescent material may e.g. be $M_2Si_5N_8$:$Eu^{2+}$ and/or $MAlSiN_3$:$Eu^{2+}$ and/or $Ca_2AlSi_3O_2N_5$:$Eu^{2+}$, etc., wherein M comprises one or more of Ba, Sr and Ca, especially in embodiments at least Sr. In specific embodiments, the first luminescent may comprise one or more materials selected from the group consisting of (Ba,Sr,Ca)S:Eu, (Ba,Sr,Ca)AlSiN_3:Eu and (Ba,Sr,Ca)_2Si_5N_8:Eu. In these compounds, europium (Eu) is substantially or only divalent, and replaces one or more of the indicated divalent cations. In general, Eu will not be present in amounts larger than 10% of the cation; its presence will especially be in the range of about 0.5 to 10%, more especially in the range of about 0.5 to 5% relative to the cation(s) it replaces. The term ":Eu", indicates that part of the metal ions is replaced by Eu (in these examples by $Eu^{2+}$). For instance, assuming 2% Eu in CaAlSiN_3:Eu, the correct formula could be $(Ca_{0.98}Eu_{0.02})AlSiN_3$.

Any of the aspects described above may be provided alone or in combination with any of the embodiments as described above.

These and other aspects of the invention will be apparent from and elucidated with reference to the embodiment(s) described hereinafter.

BRIEF DESCRIPTION OF THE DRAWINGS

Embodiments of the invention will now be described with reference to the accompanying figures, in which:

Figure 1 shows a schematic view of a white light emitting device according to an embodiment of the invention.
Figure 2 shows a schematic view of a white light emitting device according to an embodiment of the invention.
Figure 3A shows a substrate and string of blue LEDs as a LED filament in a device and
Figure 3B shows the device configured as a LED filament bulb according to an embodiment of the invention.
Figures 4A-B show two and three interdigitating electrode tracks respectively on a substrate of a white light emitting device.
Figure 5A shows a graph of efficiency versus current density of a white light emitting device comprising a series of blue LED chips.
Figure 5B shows a graph of wall plug efficiency (WPE) of the series of blue LED chips (without phosphor covering over the LED chips) versus current density of the current flowing through these chips.
Figures 6A-C show graphs of relative radiant power versus wavelength for devices comprising a phosphor material composition comprising: in 6A) only a green phosphor; in 6B) a green phosphor and broad spectrum red phosphor; and in 6C) a green phosphor and a narrow band red phosphor.
Figures 7A and 7B show spectral power distribution for two different devices; in 7a) the device has a ccy on the black body locus and in 7b) the device has a ccy of around 0.03 higher than the black body locus according to an embodiment of the invention;

Figure 8 shows the human eye sensitive function for different colors;

Figures 9 and 10 show the defined higher y color coordinates coverage above ANSI C78.377 bin range; and

Figure 11 shows the parameters of MacAdam ellipse.

DETAILED DESCRIPTION OF THE EMBODIMENTS

In an aspect, there is provided a white light emitting device comprising: a substrate; at least one string of blue LED chips mounted on the substrate, with a dominant wavelength in the range from 445nm to 460nm; and a phosphor material composition comprising: a yellow green phosphor material which generates light with a peak emission wavelength in a range 520nm to 580nm; and a narrow band red phosphor material which generates light with a peak emission wavelength in a range 625nm to 635nm; wherein the phosphor material composition comprises the narrow band red phosphor material in an amount of from 33 to 49 wt. % for a CCT of from 4000 to 6500K or in an amount of from 60 to 70 wt. % for a CCT of from 2700 to 3500K CCT; and wherein the device is adapted to generate a white light output with an efficiency of at least 230lm/W at a blue LED chip input current density in a range from 10 to 60 mA/mm$^2$.

In embodiments, the weight percentages of the phosphor materials in the phosphor material compositions of the devices can vary and depend on the CCT that is desired.

For narrow band red phosphor, for a CCT of from 4000 to 6500 K, the weight percentage is from 26 to 56 wt. %. For example, the weight percentage can be from 33 to 49 wt. %. The weight percentage can also be from 44 to 54 wt. % in some embodiments. In further embodiments, this can be 49 %, for a CCT of 4000K. The weight percentage can also be from 33 to 43 wt. %, and, in further embodiments, 38 wt. %, for a CCT of from 5000 to 6000K. For a CCT of from 2700 to 3500K, the weight percentage of the narrow band red phosphor is from 55 to 74 wt. %. For example, the weight percentage can be from 64 to 66 wt. %. More specifically, the weight percentages of the narrow band red phosphor materials for the corresponding CCTs can be: for 2700K, between 60 to 74 wt. % and, in further embodiments, 67 wt. %; for 3000K, between 55 to 69 wt. % and, in further embodiments, 62 wt. %; for 4000K, between 42 to 56 wt. % and, in further embodiments, 49 wt. %; and for 6500 K, between 26 to 40 wt. % and, in further embodiments, 33 wt. %.

For the yellow green phosphor material, for a CCT of from 4000K to 6500K, the yellow green phosphor weight material percentage can be from 44 to 74 wt. %. For a CCT of from 2700 to 3500 K, the yellow green phosphor material weight percentage can be from 22 to 45 wt. %.

Examples of the weight percentages in embodiments of the invention can therefore be, for a CCT of 4000K, 49 wt. % narrow band red phosphor and 51 wt. % yellow green phosphor and, for a CCT of 6500K, 33 wt. % narrow band red phosphor and 67 wt. % yellow green phosphor.

The weight percentage of the broad spectrum red phosphor material may be from 1 to 4 wt. %. For example the weight percentage may be 3 wt. %. An example of a device in accordance with an embodiment of the invention comprising a broad red phosphor for a CCT of 2700K can therefore comprise: a narrow band red phosphor at 67 wt. %; a yellow green phosphor at 30 wt. % and a broad spectrum red phosphor at 3 wt. %. An example of another device in accordance with an embodiment of the invention comprising a broad red phosphor for a CCT of 3000K can comprise: a narrow band red phosphor at 62 wt. %; a yellow green phosphor at 35 wt. % and a broad spectrum red phosphor at 3 wt. %.

Embodiments for which the device comprises a LED filament can comprise a single or multiple LED filaments arranged in multiple ways. For example, a single or multiple LED filament(s) could be arranged in various shapes such as spiral(s), coil(s), ring(s), or rod(s) inside a bulb or any alternative housing shape such as a cube, cylinder or ellipsoid. The LED filament can comprise multiple types of substrate such as glass or ceramic or sapphire. Particularly, sapphire substrates in LED filaments can provide an additional 1-2 % efficiency gain owing to their increased transparency (compared to glass or ceramic substrates) which contributes to more backside white light output.

Embodiments which comprise either a two or three-finger layout can be arranged in a variety of ways and the device can comprise single two or three-finger layouts or multiple two or three-finger-layouts.

The size of the blue LED chip in embodiments of the invention can also vary. In some cases the size is between 0.18-0.30 mm$^2$. In some embodiments the size of the chip is 0.2 mm$^2$.

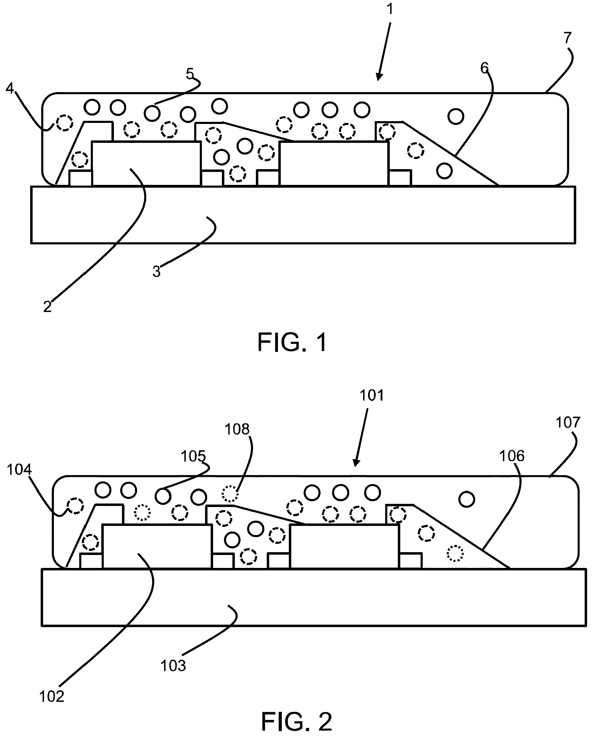

The invention will be described with reference to the Figures. A first embodiment of the invention is shown in Figure 1. A white light emitting device 1 comprises blue LED chips 2 mounted on a substrate 3. A phosphor material composition comprising a yellow green phosphor material 4 and a narrow band red phosphor material 5 is deposited over blue LED chips 2. The blue LED chips 2 and phosphor material composition of this device are sealed inside the device by an encapsulant 7. Wiring 6 is provided to connect blue LEDs 2.

In one specific implementation of the embodiment of Figure 1, the device has a CCT of 4000K and the phosphor material composition comprises 49 wt. % narrow band red phosphor 5 and 51 wt. % yellow green phosphor 4.

A further embodiment of the invention is shown in Figure 2. A white light emitting device 101 comprises blue LED chips 102 mounted on a substrate 103. A phosphor material composition comprising: a yellow green phosphor material 104; a narrow band red phosphor material 105; and a broad spectrum red phosphor material 108 is deposited over blue LED chips 102. The blue LED chips 102 and phosphor material composition of this device are sealed inside the device by an encapsulant 107. Wiring 106 is provided to connect blue LEDs 102.

In one specific implementation of the embodiment of Figure 2, the device has a CCT of 2700K and the phosphor material composition of this embodiment comprises: a narrow band red phosphor at 67 wt. %; a yellow green phosphor at 30 wt. % and a broad spectrum red phosphor at 3 wt. %.

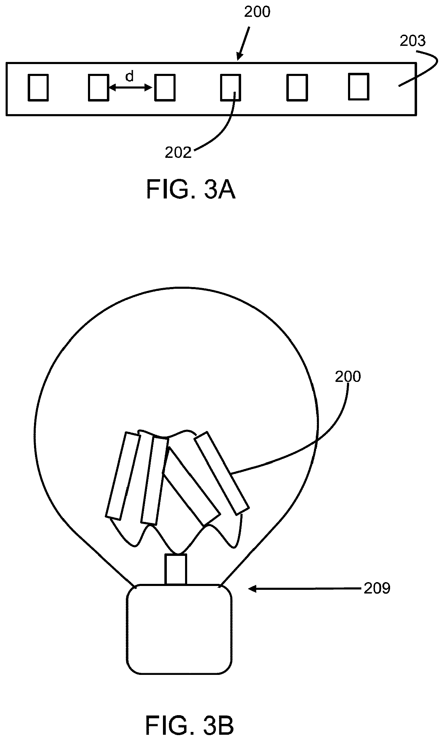

Figure 3A shows a LED filament 200 of a white light emitting device. The LED filament 200 comprises a substrate 203 and a string of blue LED chips 202. The string of blue LED chips 202 are mounted onto substrate 203. Each blue LED chip 202 has a size of 0.18mm$^2$ to 0.30mm$^2$ and is separated from the adjacent blue LED chip 202 by a distance d of at least 0.4mm.

Figure 3B shows a further embodiment of the invention in which a white light emitting device 204 comprises four of the LED filaments 200 of Figure 3A. In alternative embodiments a different number of LED filaments may be used. Although not depicted, the device 204 further comprises a phosphor material composition comprising a yellow green phosphor material and a narrow band red phosphor material is deposited over blue LED chips 016. As shown in Figure 3b shows the multiple LED filaments 200 arranged in a bulb-shaped housing to mimic a traditional incandescent light bulb appearance. Substrate 203 is a sapphire substrate.

Alternatively, in a different embodiment, the device 3 of Figures 3A and 3B comprises an alternative phosphor material composition comprising: a yellow green phosphor material; a narrow band red phosphor material; and a broad spectrum red phosphor material, that is deposited over blue LED chips. The device has a CCT of 2700K, the phosphor material composition of this embodiment comprises: a narrow band red phosphor at 67 wt. %; a yellow green phosphor at 30 wt. % and a broad spectrum red phosphor at 3 wt. %.

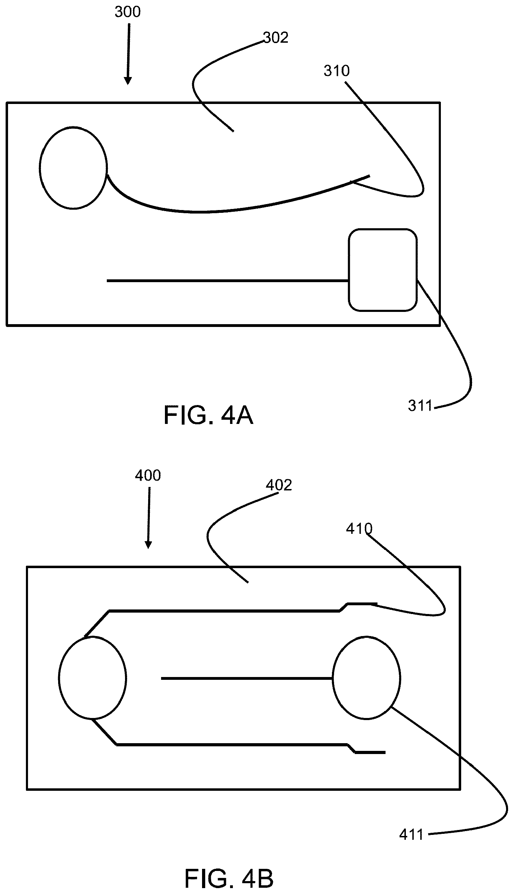

Figure 4A shows two electrodes arranged as two interdigitating elongate tracks 310 on a substrate 302 of a white light emitting device 300. This arrangement of the electrode tracks is termed a two-finger layout. Two soldering pads 311 are arranged on the substrate 302 and connect to the interdigitating electrode tracks 310. Alternatively, Figure 4B shows three electrodes arranged as three interdigitating elongate tracks 410 on a substrate 402 of a white light emitting device 400. This arrangement is termed a three-finger layout. Two soldering pads 411 are arranged on the substrate 402 and connect to the interdigitating electrode tracks 410. In embodiments, white light emitting devices can comprise the two or three-finger layouts 300 and 400 of Figures 4A and 4B. Such devices 300 and 400 can further comprise blue LED chips mounted on a substrate. Phosphor material compositions comprising a yellow green phosphor material and a narrow band red phosphor material are deposited over blue LED chips. The devices have a CCT of 4000K, the phosphor material compositions of these embodiments comprise 49 wt. % narrow band red phosphor and 51 wt. % yellow green phosphor.

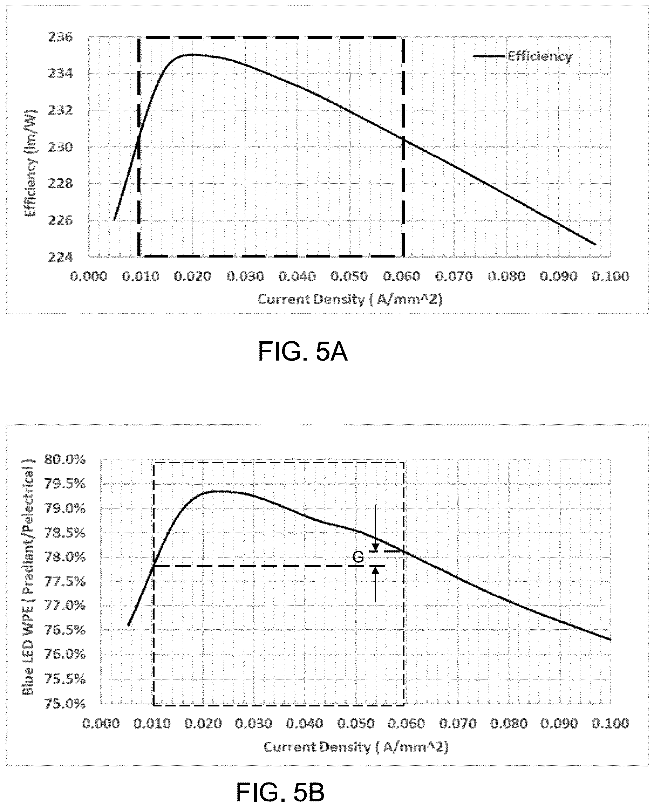

Figure 5A shows an efficiency curve at applied current densities of a white light emitting device comprising a series of blue LED chips. It has been found through experimentation that the range of the applied current densities that gives the optimum efficiency of devices according to embodiments of this invention is between 10-60 mA/mm$^2$ and preferably 20-30 mA/mm$^2$ and in some embodiments it is 25 mA/mm$^2$. After this range, the efficiency of the device falls off. Where used with the specific phosphor material composition and/or the other efficiency improvements disclosed herein, it has been found that this can be unexpectedly be further improved at this current density to provide an increased lm/W output. Figure 5B shows the wall plug efficiency (WPE) curve of the series of blue LED chips, without phosphor covering over the LED chips, at applied current density. It can be seen that, comparing with the curve in Figure 5A, when the current density increases over the peak, the WPE (of blue LED chips) decreases much slower than efficiency (of white light emitting device) does, for example, in Figure 5A, both around 10 and 60 mA/mm$^2$ reach 230 lm/W, but in Figure 5B, the WPE of 60 mA/mm$^2$ is higher than that of 10 mA/mm$^2$, at a gap G. The reason of such a quick decrease of efficiency with respect to current density in the white light emitting device is the thermal sensitivity of narrow band red phosphor material, e.g., KSF phosphor. The combination of the phosphor composition and the setting of the specific current density according to the present disclosure togather contribution to the increased lm/W output as high as 230 lm/W.

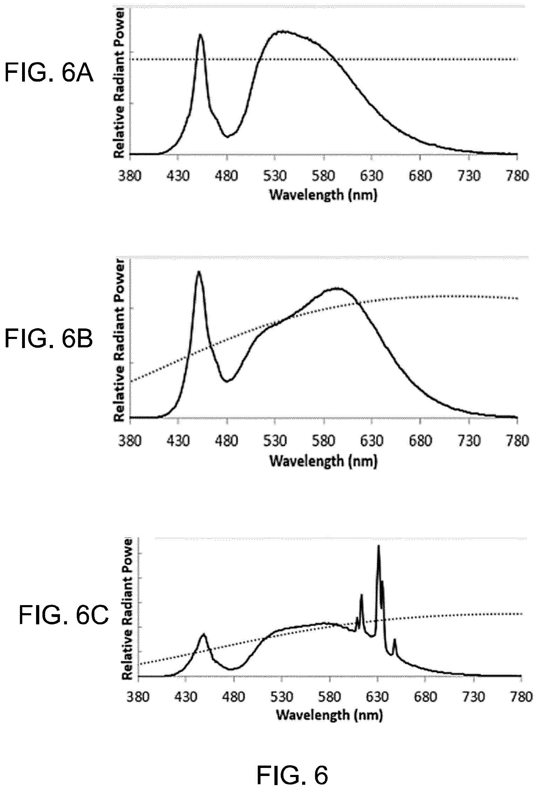

Figure 6A shows a spectral power distribution for a device, not in accordance with the invention, comprising a yellow green phosphor material only in the phosphor material composition. Using only a yellow green phosphor material can achieve relatively high efficiency, but this is to the detriment of the color -rendering index. Figure 6B shows a spectral power distribution for a device comprising a phosphor material composition comprising both a green and broad red phosphor materials, not in accordance with the invention. The color -rendering index properties are improved compared to the distribution for the device shown in Figure 6A. Figure 6C shows a spectral power distribution for a device with a green phosphor and a narrow band red phosphor in the phosphor material composition in accordance with the invention. In this embodiment, the color -rendering index properties of the device are much improved and the radiant powder of the red is seen to be much higher than for the other two devices.

Radiant power is measured in Watts and is defined as the amount of light emitted from a source irrelevant of the direction it is emitted at each wavelength. In embodiments, radiant power measurement is carried out using of a spectrophoto- or spectroradiometer connected to an integrating sphere.

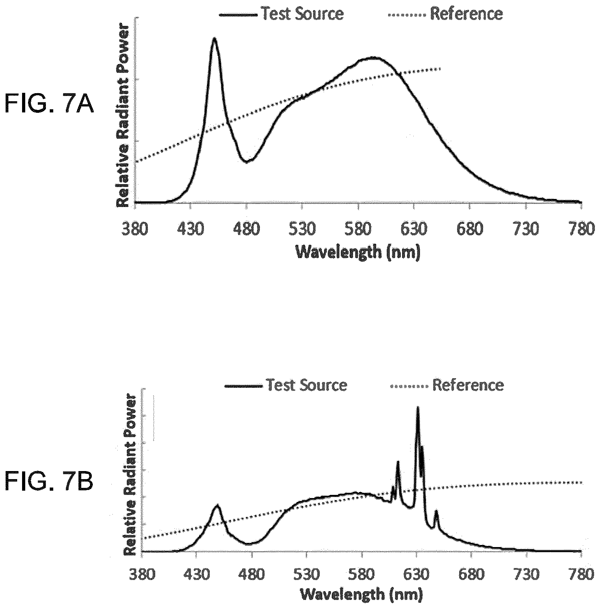

Figure 7A shows a spectral power distribution for a device not in accordance with an embodiment of the invention for a CCT of 4000K. Figure 7B shows a spectral power distribution for a device in accordance with an embodiment of the invention. This device is seen to have much higher efficiency owing to the incorporation of the narrow band red phosphor in the specified phosphor weight percentage range at the CCT of 4000K.

Examples of phosphor material compositions within devices

The following are examples of devices in accordance with embodiments of the invention, with the current density and resulting efficiency as shown in Figure 5A.

Table 1

| No. | CCT (K) | Yellow green phosphor (wt. %) | Broad spectrum red phosphor (wt. %) | Narrow band red phosphor (wt. %) |
|---|---|---|---|---|
| 1 | 2700 | 30 | 3 | 67 |
| 2 | 3000 | 35 | 3 | 62 |
| 3 | 4000 | 51 | 0 | 49 |
| 4 | 6500 | 67 | 0 | 33 |

These examples comprise the preferred amounts of narrow band red phosphor material in the device for a given CCT. The resulting ratios of the narrow band red phosphor to the yellow green phosphor within the phosphor material composition have been found to exhibit the highest device efficiency at low blue LED chip input current densities in the specified range. This contributes to the overall device efficiency owing to the increase in the phosphor conversion efficiency as described with reference to equation (1).

By incorporating other above-mentioned features into the device, such as a LED filament, blue LED chip spacing of greater than 0.4 mm and a two-finger layout (in addition to the preferred narrow band red phosphor material weigh percentages in Table 1), the efficiency of the device can be further improved above 230 lm/W. This is due to the corresponding increases in wall plug efficiency and package efficiency as discussed with reference to equation (1).

Accordingly, it has been found that a device comprising: a chip size of 0.2 mm$^2$; a two-finger layout; a chip spacing of greater than 0.5 mm and an input current density of the blue LED chip at 0.025A/mm$^2$ can have the highest maximum white LED efficiency point with the specified weight percentages given in Table 1.

These examples comprise the preferred amounts of narrow band red phosphor material in the device for a given CCT. The resulting ratios of the narrow band red phosphor to the yellow green phosphor within the phosphor material composition have been found to exhibit the highest device efficiency at low blue LED chip input current densities in the specified range. This contributes to the overall device efficiency owing to the increase in the phosphor conversion efficiency as described with reference to equation (1).

By incorporating other above-mentioned features into the device, such as a LED filament, blue LED chip spacing of greater than 0.4 mm and a two-finger layout (in addition to the preferred narrow band red phosphor material weigh percentages in Table 1), the efficiency of the device can be further improved above 230 lm/W. This is due to the corresponding increases in wall plug efficiency and package efficiency as discussed with reference to equation (1).

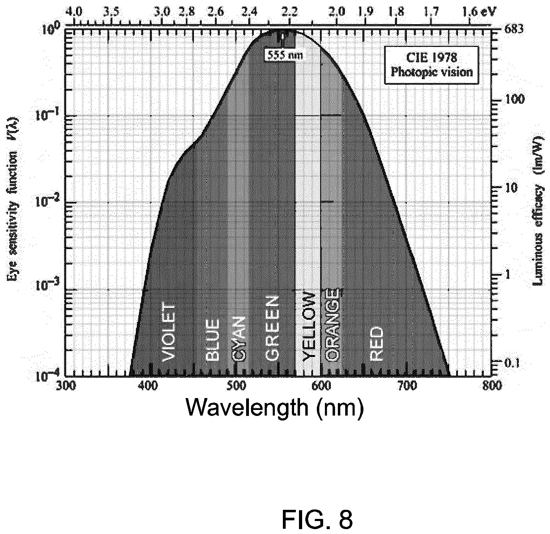

Figure 8 shows the human eye sensitive function for different color. The green spectrum has highest weight percentage than red or blue colors.

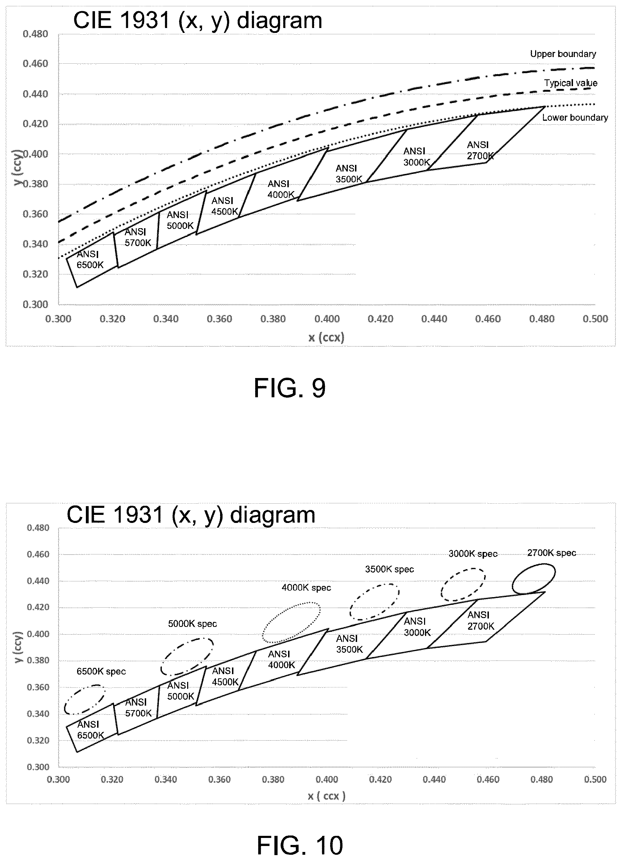

Figures 9 and 10 show the defined higher y color coordinates coverage above ANSI C78.377 bin range to get higher efficiency in white color. The "bin range" refers to the chromaticity specification for SSL products defined in Annex A of ANSI C78.377, "7-Step Quadrangles". In Figure 9 the CIE 1931 diagram shows the upper and lower limited color range that have higher ccy coordinate than ANSI C78.377 bin range. In Figure 10, the CIE 1931 diagram shows examples of MacAdam ellipse ranges according to ANSI standard C78.376 that have higher ccy coordinate than ANSI C78.377 bin range.

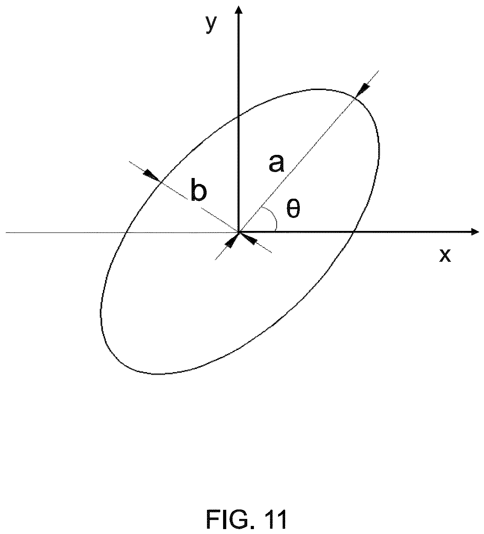

Figure 11 shows the parameters a/b/θ of a Macadam ellipse.

Variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality.

The mere fact that certain measures are recited in mutually different dependent claims does not indicate that a combination of these measures cannot be used to advantage.

If the term "adapted to" is used in the claims or description, it is noted the term "adapted to" is intended to be equivalent to the term "configured to".

**Claims**

1. A white light emitting device comprising:

a substrate;
at least one string of blue LED chips mounted on the substrate, with a dominant wavelength in the range from 445nm to 460nm; and
a phosphor material composition comprising:

a yellow green phosphor material which generates light with a peak emission wavelength in a range 520 nm to 580 nm; and
a narrow band red phosphor material which generates light with a peak emission wavelength in a range 625 nm to 635 nm;

wherein the phosphor material composition comprises the narrow band red phosphor material in an amount of from 33 to 49 wt. % for a CCT of from 4000 to 6500K or in an amount of from 60 to 70 wt. % for a CCT of from 2700 to 3500K CCT; and
wherein the device is adapted to generate a white light output with an efficiency of at least 230 lm/W at a blue LED chip input current density in a range from 10 to 60 mA/mm$^2$.

2. The device of claim 1, wherein the blue LED chip input current density is in a range of 20 to 30 mA/mm$^2$.

3. The device of claim 1 or claim 2, wherein phosphor material composition comprises the narrow band red phosphor material in an amount of from 33 to 43 wt. % for a CCT of from 5000K to 6500K.

4. The device of claim 1 or claim 2, wherein the phosphor material composition comprises the yellow green phosphor material in an amount of from 44 to 74 wt. % for a CCT of from 4000 to 6500K or from 22-45 wt. % for a CCT of from 2700 to 3500K.

5. The device of claim 1 or claim 2, wherein the phosphor material composition comprises the yellow green phosphor material in an amount of from 51 to 67 wt. % and the narrow band red phosphor material in an amount of is from 33 to 49 wt. % for a CCT of from 4000 to 6500K.

6. The device of claim 1 or claim 2,

wherein, for a CCT of between 2700 to 3500K, the phosphor material composition further comprises a broad spectrum red phosphor material; and
wherein, for a CCT of between 2700 to 3500K, the phosphor material composition comprises:

the broad spectrum red phosphor material in an amount of from 1 to 4 wt. %;
the yellow green phosphor material in an amount of from 30 to 35 wt. %; and
the narrow band red phosphor material in an amount of from 64 to 67 wt. %.

7. A white light emitting device comprising:

a substrate.
at least one string of blue LED chips mounted on the substrate, with a dominant wavelength in the range from 445 nm to 460 nm; and
a phosphor material composition comprising:

a yellow green phosphor material which generates light with a peak emission wavelength in a range 520 nm to 580 nm; and
a narrow band red phosphor material which generates light with a peak emission wavelength in a range 625 nm to 635 nm;

wherein the device is adapted to generate a white light output with an efficiency of at least 230 lm/W at a blue LED chip input current density in a range from 10 to 60 mA/mm$^2$, and wherein a color point (x, y) of the white light output with respect to the chromaticity specification for SSL products defined in 7-Step Quadrangles of Annex A in ANSI standard C78.377 is within the range of:

$$0.300 < x < 0.500;$$

and

$$-2.3172\, x^2 + 2.3653\, x - 0.170 < y < -2.3172\, x^2 + 2.3653\, x - 0.146;$$

wherein, x and y are chromaticity coordinates according to CIE 1931 color diagram.

8. The device of claim 7, wherein the color point range of the white light output is above the black body locus and at a distance to the black body locus of at least 5 SDCM.

9. The device of claim 7 or claim 8, wherein the device is adapted to generate a white light output with an efficiency of at least 230 lm/W at a blue LED chip input current density in a range from 15 to 40 mA/mm$^2$.

10. The device of claim 1 or claim 2 or claim 7 or claim 8, wherein the ccy position of the white light output is in a range 0.02-0.03 higher than the blackbody curve.

11. The device of claim 1 or claim 2 or claim 7 or claim 8, wherein the substrate and the string of blue LED chips are arranged as a LED filament.

12. The device of claim 1 or claim 2 or claim 7 or claim 8, wherein the yellow green phosphor material comprises YAG, GaYAG or LuYAG; and wherein the narrow band red phosphor material comprises $K_2SiF_6$:$Mn^{4+}$.

13. The device of claim 1 or claim 2 or claim 7 or claim 8,

    wherein for a CCT of between 4000K to 6500K, the accumulated spectrum intensity ratio from 480nm to 600nm is higher than 50% of the total white spectrum from 380nm to 780nm; or
    wherein for a CCT of between 2700K to 3500K, the accumulated spectrum intensity ratio from 480nm to 600nm is higher than 45% of the total white spectrum.

14. The device of claim 1 or claim 2 or claim 7 or claim 8, wherein the blue LED chip size is in the range 0.18mm$^2$ to 0.30mm$^2$.

15. The device of any of claims 1 to 14, wherein the blue LED chip to chip distance is equal or greater than 0.4mm.

**Patentansprüche**

1. Weißlichtemittierende Vorrichtung, umfassend:

    ein Substrat;
    mindestens eine Reihe von blauen LED-Chips, die auf dem Substrat montiert sind, mit einer dominanten Wellenlänge im Bereich von 445 nm bis 460 nm; und
    eine Leuchtstoffmaterialzusammensetzung, umfassend:

        ein gelbgrünes Leuchtstoffmaterial, das Licht mit einer Spitzenemissionswellenlänge in einem Bereich von 520 nm bis 580 nm erzeugt; und
        ein schmalbandiges rotes Leuchtstoffmaterial, das Licht mit einer Spitzenemissionswellenlänge in einem Bereich von 625 nm bis 635 nm erzeugt;
        wobei die Leuchtstoffmaterialzusammensetzung das schmalbandige rote Leuchtstoffmaterial in einer Menge von 33 bis 49 Gew.-% für eine CCT von 4000 bis 6500 K oder in einer Menge von 60 bis 70 Gew.-% für eine CCT von 2700 bis 3500 K CCT umfasst; und
        wobei die Vorrichtung dazu ausgelegt ist, eine Weißlichtausgabe mit einer Effizienz von mindestens 230 lm/W bei einer Eingangsstromdichte des blauen LED-Chips in einem Bereich von 10 bis 60 mA/mm$^2$ zu

erzeugen.

2. Vorrichtung nach Anspruch 1, wobei die Eingangsstromdichte des blauen LED-Chips in einem Bereich von 20 bis 30 mA/mm$^2$ liegt.

3. Vorrichtung nach Anspruch 1 oder Anspruch 2, wobei die Leuchtstoffmaterialzusammensetzung das schmalbandige rote Leuchtstoffmaterial in einer Menge von 33 bis 43 Gew.-% für eine CCT von 5000 K bis 6500 K umfasst.

4. Vorrichtung nach Anspruch 1 oder Anspruch 2, wobei die Leuchtstoffmaterialzusammensetzung das gelbgrüne Leuchtstoffmaterial in einer Menge von 44 bis 74 Gew.-% für eine CCT von 4000 bis 6500 K oder von 22 bis 45 Gew.-% für eine CCT von 2700 bis 3500 K umfasst.

5. Vorrichtung nach Anspruch 1 oder Anspruch 2, wobei die Leuchtstoffmaterialzusammensetzung das gelbgrüne Leuchtstoffmaterial in einer Menge von 51 bis 67 Gew.-% und das schmalbandige rote Leuchtstoffmaterial in einer Menge von 33 bis 49 Gew.-% für eine CCT von 4000 bis 6500 K umfasst.

6. Vorrichtung nach Anspruch 1 oder Anspruch 2,

   wobei für eine CCT zwischen 2700 und 3500 K die Phosphormaterialzusammensetzung zusätzlich ein rotes Breitspektrum-Leuchtstoffmaterial umfasst; und
   wobei die Phosphormaterialzusammensetzung für eine CCT zwischen 2700 und 3500 K umfasst:

   das rote Breitspektrum-Leuchtstoffmaterial in einer Menge von 1 bis 4 Gew.-%;
   das gelbgrüne Leuchtstoffmaterial in einer Menge von 30 bis 35 Gew.-% und
   das schmalbandige rote Leuchtstoffmaterial in einer Menge von 64 bis 67 Gew.-%.

7. Weißlichtemittierende Vorrichtung, umfassend:

   ein Substrat.
   mindestens eine Reihe von blauen LED-Chips, die auf dem Substrat montiert sind, mit einer dominanten Wellenlänge im Bereich von 445 nm bis 460 nm; und
   eine Leuchtstoffmaterialzusammensetzung, umfassend:

   ein gelbgrünes Leuchtstoffmaterial, das Licht mit einer Spitzenemissionswellenlänge im Bereich von 520 nm bis 580 nm erzeugt; und
   ein schmalbandiges rotes Leuchtstoffmaterial, das Licht mit einer Spitzenemissionswellenlänge in einem Bereich von 625 nm bis 635 nm erzeugt;
   wobei die Vorrichtung dazu ausgelegt ist, eine Weißlichtausgabe mit einer Effizienz von mindestens 230 lm/W bei einer Eingangsstromdichte des blauen LED-Chips in einem Bereich von 10 bis 60 mA/mm$^2$ zu erzeugen, und wobei ein Farbpunkt (x, y) der Weißlichtausgabe mit Bezug auf die Farbartspezifikation für SSL-Produkte, die in den "7-Sept Quadrangles" von Anhang A im ANSI-Standard C78.377 definiert ist, im folgenden Bereich liegt:

$$0,300 < x < 0,500;$$

   und

$$-2,3172\, x^2 + 2,3653\, x - 0,170 < y < -2,3172\, x^2 + 2,3653\, x - 0,146;$$

   wobei x und y Farbartkoordinaten gemäß dem Farbdiagramm CIE 1931 sind.

8. Vorrichtung nach Anspruch 7, wobei der Farbpunktbereich der Weißlichtausgabe über dem Plankschen Kurvenzug und in einem Abstand zum Plankschen Kurvenzug von mindestens 5 SDCM liegt.

9. Vorrichtung nach Anspruch 7 oder Anspruch 8, wobei die Vorrichtung dazu ausgelegt ist, eine Weißlichtausgabe mit einer Effizienz von mindestens 230 lm/W bei einer Eingangsstromdichte des blauen LED-Chips in einem Bereich von 15 bis 40 mA/mm$^2$ zu erzeugen.

10. Vorrichtung nach Anspruch 1 oder Anspruch 2 oder Anspruch 7 oder Anspruch 8, wobei die ccy-Position der Weißlichtausgabe in einem Bereich von 0,02 bis 0,03 höher als die Kurve des schwarzen Körpers liegt.

11. Vorrichtung nach Anspruch 1 oder Anspruch 2 oder Anspruch 7 oder Anspruch 8, wobei das Substrat und die Reihe von blauen LED-Chips als LED-Filament angeordnet sind.

12. Vorrichtung nach Anspruch 1 oder Anspruch 2 oder Anspruch 7 oder Anspruch 8, wobei das gelbgrüne Leuchtstoffmaterial YAG, GaYAG oder LuYAG umfasst; und wobei das schmalbandige rote Leuchtstoffmaterial K$_2$SiFe:Mn$^{4+}$ umfasst.

13. Vorrichtung nach Anspruch 1 oder Anspruch 2 oder Anspruch 7 oder Anspruch 8,

  wobei für eine CCT zwischen 4000 K und 6500 K das akkumulierte Spektrum intensitätsverhältnis von 480 nm bis 600 nm höher als 50 % des gesamten weißen Spektrums von 380 nm bis 780 nm ist; oder
  wobei für eine CCT zwischen 2700 K und 3500 K das akkumulierte Spektrum intensitätsverhältnis von 480 nm bis 600 nm höher als 45 % des gesamten weißen Spektrums ist.

14. Vorrichtung nach Anspruch 1 oder Anspruch 2 oder Anspruch 7 oder Anspruch 8, wobei die Größe des blauen LED-Chips im Bereich von 0,18 mm$^2$ bis 0,30 mm$^2$ liegt.

15. Vorrichtung nach einem der Ansprüche 1 bis 14, wobei der Abstand zwischen dem blauen LED-Chip und Chip mindestens 0,4 mm beträgt.


**Revendications**

1. Dispositif émettant de la lumière blanche comprenant :

  un substrat ;
  au moins un chapelet de puces DEL bleues monté sur le substrat, avec une longueur d'onde dominante dans la plage allant de 445 nm à 460 nm ; et
  une composition de matériau luminophore comprenant :

    un matériau luminophore jaune vert qui génère de la lumière avec une longueur d'onde d'émission maximale dans une plage de 520 nm à 580 nm ; et
    un matériau luminophore rouge à bande étroite qui génère de la lumière avec une longueur d'onde d'émission maximale dans une plage de 625 nm à 635 nm ;
    dans lequel la composition de matériau luminophore comprend le matériau luminophore rouge à bande étroite en une quantité allant de 33 à 49 % en poids pour une TCC allant de 4000 à 6500 K ou en une quantité allant de 60 à 70 % en poids pour une TCC allant de 2700 à 3500 K TCC ; et
    dans lequel le dispositif est conçu pour générer une sortie de lumière blanche avec une efficacité d'au moins 230 lm/W à une densité de courant d'entrée de puce DEL bleue dans une plage allant de 10 à 60 mA/mm$^2$

2. Dispositif selon la revendication 1, dans lequel la densité de courant d'entrée de puce DEL bleue est dans une plage de 20 à 30 mA/mm$^2$.

3. Dispositif selon la revendication 1 ou la revendication 2, dans lequel la composition de matériau luminophore comprend le matériau luminophore rouge à bande étroite en une quantité allant de 33 à 43 % en poids pour une TCC allant de 5000 K à 6500 K.

4. Dispositif selon la revendication 1 ou la revendication 2, dans lequel la composition de matériau luminophore comprend le matériau luminophore jaune vert en une quantité allant de 44 à 74 % en poids pour une TCC allant de 4000 à 6500 K ou de 22 à 45 % en poids pour une TCC allant de 2700 à 3500 K.

5. Dispositif selon la revendication 1 ou la revendication 2, dans lequel la composition de matériau luminophore comprend le matériau luminophore jaune vert en une quantité allant de 51 à 67 % en poids et le matériau luminophore rouge à bande étroite en une quantité allant de 33 à 49 % en poids pour une TCC allant de 4000 à 6500 K.

6. Dispositif selon la revendication 1 ou la revendication 2,

dans lequel, pour une TCC comprise de 2700 à 3500 K, la composition de matériau luminophore comprend en outre un matériau luminophore rouge à large spectre ; et
dans lequel, pour une TCC comprise de 2700 à 3500K, la composition de matériau luminophore comprend :

le matériau luminophore rouge à large spectre en une quantité allant de 1 à 4 % en poids ;
le matériau luminophore jaune vert en une quantité allant de 30 à 35 % en poids ; et le matériau luminophore rouge à bande étroite en une quantité allant de 64 à 67 % en poids.

7. Dispositif émettant de la lumière blanche comprenant :

un substrat.
au moins un chapelet de puces DEL bleues monté sur le substrat, avec une longueur d'onde dominante dans la plage allant de 445 nm à 460 nm ; et
une composition de matériau luminophore comprenant :

un matériau luminophore jaune vert qui génère de la lumière avec une longueur d'onde d'émission maximale dans une plage de 520 nm à 580 nm ; et
un matériau luminophore rouge à bande étroite qui génère de la lumière avec une longueur d'onde d'émission maximale dans une plage de 625 nm à 635 nm ;
dans lequel le dispositif est conçu pour générer une sortie de lumière blanche avec une efficacité d'au moins 230 lm/W à une densité de courant d'entrée de puce DEL bleue dans une plage allant de 10 à 60 mA/mm$^2$, et dans lequel un point de couleur (x, y) de la sortie de lumière blanche par rapport à la spécification de chromaticité pour produits SSL définie dans des quadrangles à 7 étapes de l'Annexe A dans la norme ANSI C78.377 est dans la plage de :

$$0{,}300 < x < 0{,}500 \;;$$

et

$$-2{,}3172\,x^2 + 2{,}3653\,x - 0{,}170 < y < -2{,}3172\,x^2 + 2{,}3653\,x - 0{,}146 \;;$$

dans lequel, x et y sont des coordonnées de chromaticité selon le diagramme de couleur CIE 1931.

8. Dispositif selon la revendication 7, dans lequel la plage de point de couleur de la sortie de lumière blanche est au-dessus du lieu de corps noir et à une distance par rapport au lieu de corps noir d'au moins 5 SDCM.

9. Dispositif selon la revendication 7 ou la revendication 8, dans lequel le dispositif est conçu pour générer une sortie de lumière blanche avec une efficacité d'au moins 230 lm/W à une densité de courant d'entrée de puce DEL bleue dans une plage allant de 15 à 40 mA/mm$^2$.

10. Dispositif selon la revendication 1 ou la revendication 2 ou la revendication 7 ou la revendication 8, dans lequel la position ccy de la sortie de lumière blanche est dans une plage de 0,02 à 0,03 plus élevée que la courbe de corps noir.

11. Dispositif selon la revendication 1 ou la revendication 2 ou la revendication 7 ou la revendication 8, dans lequel le substrat et le chapelet de puces DEL bleues sont agencés en tant que filament à DEL.

12. Dispositif selon la revendication 1 ou la revendication 2 ou la revendication 7 ou la revendication 8, dans lequel le matériau luminophore jaune vert comprend YAG, GaYAG ou LuYAG ; et dans lequel le matériau luminophore rouge à bande étroite comprend $K_2SiF_6$:$Mn^{4+}$.

13. Dispositif selon la revendication 1 ou la revendication 2 ou la revendication 7 ou la revendication 8,

dans lequel pour une TCC comprise de 4000 K à 6500 K, le rapport d'intensité de spectre cumulé de 480 nm à 600 nm est supérieur à 50 % du spectre blanc total de 380 nm à 780 nm ; ou
dans lequel pour une TCC comprise de 2700 K à 3500 K, le rapport d'intensité de spectre cumulé de 480 nm à 600 nm est supérieur à 45 % du spectre blanc total.

14. Dispositif selon la revendication 1 ou la revendication 2 ou la revendication 7 ou la revendication 8, dans lequel la taille de puce DEL bleue est dans la plage de 0,18 mm$^2$ à 0,30 mm$^2$.

15. Dispositif selon l'une quelconque des revendications 1 à 14, dans lequel la distance de puce à puce DEL bleue est égale ou supérieure à 0,4 mm.

FIG. 1

FIG. 2

FIG. 3A

FIG. 3B

FIG. 4A

FIG. 4B

FIG. 5A

FIG. 5B

FIG. 6A

FIG. 6B

FIG. 6C

FIG. 6

FIG. 7A

FIG. 7B

FIG. 8

FIG. 9

FIG. 10

FIG. 11

**REFERENCES CITED IN THE DESCRIPTION**

**Patent documents cited in the description**

- US 2017342320 A
- WO 2020190921 A
- WO 2017021087 A